# EUROPEAN PATENT APPLICATION

(11) **EP 4 538 792 A2**
(43) Date of publication of application: **16.04.2025**
(21) Application number: 24175683.2
(22) Date of filing: 14.05.2024
(51) Int. Cl.: G03F 1/24, G03F 1/54, G03F 1/48, G03F 1/80

(54) **PHASE SHIFT BLANKMASK AND PHOTOMASK FOR EUV LITHOGRAPHY WITH ABSORBING FILM OF CRSB(N,O,C)**

(30) Priority: 11.10.2023 KR 20230134754
(71) Applicant: S&S Tech Co., Ltd., Daegu 42714 (KR)
(72) Inventor: YANG, Chul-Kyu, 42714 Daegu (KR); WOO, Mi-Kyung, 42714 Daegu (KR); KIM, Yong-Dae, 42714 Daegu (KR)
(74) Representative: ABG Intellectual Property Law, S.L.

(57) **Abstract**

Blankmasks for EUV lithography are equipped with a reflective film formed on the substrate, a capping film formed on the reflective film, and an absorption film formed on the capping film. The absorption film includes chromium (Cr) 30-60at%, antimony (Sb) 40-70at%, and nitrogen (N) 0-20(at%). Thinning of the absorption film thickness is possible, resulting in a reduction of the 3D effect, and improvements in Dose to Space (DtS) and Normalized Image Log Slope (NILS).

## Description

### BACKGROUND

### Field

The present invention relates to a Blankmask and a Photomask, more particularly, to a binary-type extreme ultraviolet (EUV) lithography Blankmask equipped with an absorption film and a Photomask manufactured using the same.

### Description of the Related Art

Blankmasks for EUV lithography generally consist of two thin films on the substrate: a reflective film that reflects EUV light, and an absorption film that absorbs EUV light. The Photomask is created by patterning the absorption film of the Blankmask. The absorption film is patterned into a designed pattern, and as a result, the EUV exposure light with a wavelength of 13.5nm projected onto the Photomask is reflected according to the pattern of the absorption film, exposing the wafer according to the pattern.

The commercially available Blankmasks for EUV typically employ a tantalum (Ta)-based material for the absorption film. Tantalum (Ta)-based materials have the advantage of excellent cleaning and etching characteristics. However, tantalum (Ta)-based materials have a problem in that it is difficult to make the film thinner than 50nm to improve the 3D Effect by reducing the thickness. To overcome this, a material with a higher extinction coefficient (k) than tantalum (Ta) can be considered. However, materials with a high extinction coefficient (k) have poor etching and cleaning characteristics, and have not been commercialized to date.

### SUMMARY

The present invention was devised to solve the aforementioned problems, and the purpose of the present invention is to provide a method that allows the fabrication of an absorption film for a binary-type EUV Blankmask with a high extinction coefficient (k), enabling the production of an absorption film with a thickness of less than 50nm, preferably less than 40nm.

The present invention provides a blankmask for extreme ultraviolet lithography, comprising: a substrate, a reflective film formed on the substrate, a capping film formed on the reflective film, and an absorption film formed on the capping film, which includes chromium (Cr) and antimony (Sb).

The absorption film can include chromium (Cr) 30-60at%, antimony (Sb) 40-70at%, and nitrogen (N) 0-20(at%).

It is preferable that the nitrogen (N) content in the absorption film is at least 1at%.

The absorption film can further include one of oxygen (O) or carbon (C).

The absorption film can include oxygen (O) 0-10at%, and carbon (C) 0-10at%.

The absorption film has an extinction coefficient (k) of 0.05-0.065 for EUV exposure light with a wavelength of 13.5nm.

The absorption film has a refractive index (n) of 0.930-0.945 for EUV exposure light with a wavelength of 13.5nm.

The absorption film has a thickness of 30-50nm.

The absorption film has an absolute reflectivity of 3% or less for EUV exposure light with a wavelength of 13.5nm.

The blankmask of the present invention can further comprise a hardmask film formed on the absorption film, which is etched by fluorine (F)-based gas.

The blankmask of the present invention can further comprise an etch stop film formed on the absorption film, which is etched by fluorine (F)-based gas, and a hardmask film formed on the etch stop film, which is etched by chlorine (Cl)-based gas.

The etch stop film can be formed of a material including one or more of tantalum (Ta), silicon (Si), platinum (Pt).

The etch stop film has a thickness of 2nm or less.

The hardmask film can be formed of a material including CrNb or CrSb.

According to another aspect of the present invention, a photomask for extreme ultraviolet lithography manufactured using the blankmask with the abeve construction is provided.

According to the invention, by employing chromium (Cr) and antimony (Sb) as the main materials of the absorption layer, it is possible to form an absorption layer with a high extinction coefficient (k).

Consequently, the absorption layer can be made thinner, reducing the 3D effect and improving DtS (Dose to Space) and NILS (Normalized Image Log Slope), enabling superior performance during wafer printing using photomasks.

### BRIEF DESCRIPTION OF THE DRAWINGS

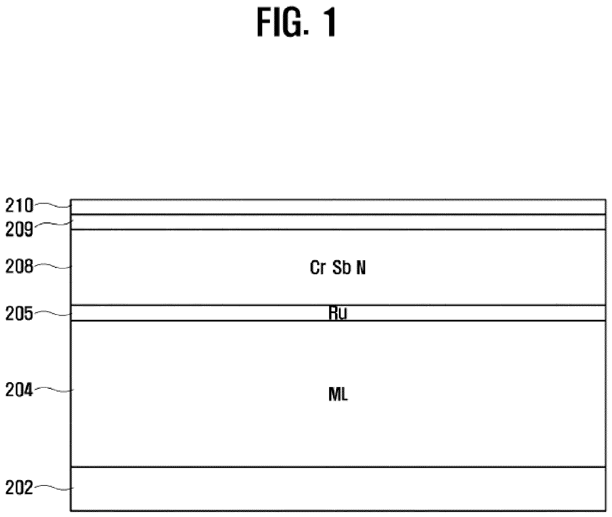

Figure 1 is a diagram showing a binary-type extreme ultraviolet (EUV) lithography Blankmask according to the present invention.

### DETAILED DESCRIPTION OF EXEMPLARY EMBODIMENTS

In the following, the invention will be described in more detail with reference to the drawings.

Figure 1 is a diagram showing a binary-type extreme ultraviolet (EUV) lithography Blankmask according to the present invention.

The binary-type EUV lithography Blankmask according to the present invention includes a substrate 202, a reflective film 204 formed on the substrate 202, a capping film 205 formed on the reflective film 204, an absorption film 208 formed on the capping film 205, a hardmask film 209 formed on the absorption film 208, and a resist film 210 formed on the hardmask film 209. Optionally, an etch stop film can be additionally provided between the capping film 205 and the absorption film 208 or between the absorption film 208 and the hardmask film 209.

The substrate 202 is made of a Low Thermal Expansion Material (LTEM) substrate suitable for a reflective Blankmask using EUV exposure light, having a low thermal expansion coefficient.

The reflective film 204 has a function of reflecting EUV exposure light and has a multilayer structure with different refractive indices for each layer. Specifically, the reflective film 204 is formed by alternately stacking layers of Mo material and Si material for 40 to 60 layers.

The capping film 205 prevents the formation of an oxide film on the reflective film 204 to maintain the reflectivity of the reflective film 204 to EUV exposure light and prevents the reflective film 204 from being etched during the patterning of the absorption film 208. The capping film 205 is formed of a material containing ruthenium (Ru) and has a thickness of 2 to 5 nm.

The absorption film 208 absorbs exposure light to transfer the pattern onto the wafer using the contrast, i.e., the difference in reflectivity of the exposure light reflected by the reflective film 204 and the absorption film 208. In this invention, the absorption film 208 is formed of a material containing chromium (Cr) and antimony (Sb).

The extinction coefficient (k) of the absorption film 208 is between 0.050 to 0.065 for EUV exposure light with a wavelength of 13.5 nm, preferably between 0.055 to 0.065. This allows the thickness of the absorption film 208 to be less than 50 nm, preferably less than 40 nm. The absorption film 208 has a refractive index (n) of 0.930 to 0.945 for EUV exposure light with a wavelength of 13.5 nm.

The ratio of chromium (Cr) to antimony (Sb) can be adjusted as a method to control the extinction coefficient (k) of the absorption film 208. Preferably, the absorption film 208 has a composition of 30-60at% chromium (Cr), 40-70at% antimony (Sb), and 0-20at% nitrogen (N). If the content of chromium (Cr) is higher than 60at%, the extinction coefficient (k) is reduced, making it difficult to thin the absorption film 208, and if the content of chromium (Cr) is lower than 30at%, it has a high extinction coefficient (k) but is vulnerable to the solutions used during cleaning.

To form the absorption film 208 with such a composition, the composition of the target in the sputtering process for forming the absorption film 208 can be controlled. Specifically, co-sputtering methods using targets of chromium (Cr), antimony (Sb), and CrSb can be applied. It is also possible to use a single target of CrSb alloy, in which case the composition of the CrSb alloy target is Cr:Sb = 30-40:70-60(at%).

The extinction coefficient (k) of the absorption film 208 can be controlled through the content of either nitrogen (N), oxygen (O), or carbon (C). Specifically, the extinction coefficient (k) decreases as the content of nitrogen (N) or oxygen (O) increases. Therefore, it is necessary to limit the content of nitrogen (N) and oxygen (O) in the absorption film 208, specifically, the content of nitrogen (N) should be limited to 20at% or less to secure a high extinction coefficient (k). However, since nitrogen (N) affects the line edge roughness after the patterning process, it is preferable to maintain a minimum content of nitrogen (N), for example, at least 1at%. The content of oxygen (O) is preferably 0-10at%, and the content of carbon (C) is preferably 0-10at%.

The absorption film 208 can be formed as a single-layer structure or as a multilayer structure with different composition ratios of the constituent materials. The absorption film 208 has a thickness of 30-50 nm, preferably 35-45 nm. The absorption film 208 has an absolute reflectivity of 3% or less, preferably 2% or less, for EUV exposure light with a wavelength of 13.5 nm.

The absorption film 208 of the present invention is etched by a chlorine (Cl₂)-based etching gas that does not contain oxygen (O₂). Thus, the capping film 205 beneath the absorption film 208 does not come into contact with oxygen (O₂), preventing damage to the capping film 205 even in the case of over-etching.

The hardmask film 209 is used as an etching mask during the etching of the absorption film 208 and is formed of a material having an etching selectivity with respect to the absorption film 208. The hardmask film 209 contains tantalum (Ta) and oxygen (O). The hardmask film 209 containing tantalum (Ta) is etched by fluorine (F)-based gas when oxygen (O) is further included. The hardmask film 209 may also contain boron (B). The content of boron (B) in the hardmask film 209 is 20at% or less, preferably 15at% or less. The hardmask film 209 has a thickness of 5 nm or less, preferably 2-4 nm.

The resist film 210 is composed of a Chemically Amplified Resist (CAR). The resist film 210 has a thickness of 40-100 nm, preferably 40-80 nm.

In the structure described above, the hardmask film 209 is configured to be etched by fluorine (F)-based gas in order to secure etching selectivity for the absorption film 208, resulting in damage to the resist film 210 during the etching process. Generally, the thickness damage of the resist film 210 during etching occurs less with chlorine (Cl₂)-based gas than with fluorine (F)-based gas. Moreover, when using chlorine (Cl₂)-based gas, using chlorine (Cl₂)-based gas that does not include oxygen (O₂) results in less thickness damage to the resist film 210. Meanwhile, the thickness of the resist film 210 directly affects the resolution of the photomask. When the resist film 210 is thick, scattering of electrons during E-beam Writing causes CD (Critical Dimension) Error. Additionally, when forming highly miniaturized patterns, an aspect ratio issue of the resist film 210 may occur. To make the resist film 210 thinner, the hardmask film 209 can be formed of a material that is etched by chlorine (Cl₂)-based gas, for example, a CrNb-based material or CrSb-based material. However, in such cases, since both the absorption film 208 and the hardmask film 209 are etched by chlorine (Cl₂)-based gas, an etch stop film that is etched by fluorine (F)-based gas can be additionally formed between the absorption film 208 and the hardmask film 209.

The etch stop film is formed of a material containing one or more of tantalum (Ta), silicon (Si), platinum (Pt), which are materials etched by fluorine (F)-based gas. Additionally, the etch stop film can further include one or more of nitrogen (N), oxygen (O), carbon (C). The etch stop film has a thickness of 4 nm or less, preferably 2 nm or less. This thin thickness minimizes the problem of difference in profile between the absorption film 208 beneath and the etch stop film during pattern formation. The etch stop film has an etching selectivity of 5 or more with respect to the absorption film 208 beneath it and also has an etching selectivity of 5 or more with respect to the hardmask film 208 above it.

The process for manufacturing the Blankmask of the present invention with the above configuration is as follows.

First, the reflective film 204 and the capping film 205 are formed on the substrate 204, followed by the formation of the absorption film 208.

The absorption film 208 is formed on the capping film 205 using a CrSbN material through a Sputtering method. The sputtering target composition for forming the absorption film 208 used a ratio of Cr:Sb = 40:60(at%), with argon (Ar) at 30sccm and nitrogen (N) at 2sccm injected, and a process power of 1.2kW was applied. The absorption film 208 showed a refractive index (n) of 0.938 and an extinction coefficient (k) of 0.0602 for EUV exposure light with a wavelength of 13.5 nm, and the composition ratio of the absorption film 208 thin film analyzed through RBS showed a ratio of Cr:Sb = 0.9:1.0.

Afterward, a TaBO hardmask film 209 was formed with a thickness of 4 nm on the absorption film 208, and the resist film 210 was coated to complete the manufacturing of the final Blankmask.

For the manufacture of the Blankmask according to another embodiment described above, an etch stop film of Ta-based material is formed on the absorption film 208, followed by the formation of a CrNbN hardmask film 209. In this case, the etch stop film is formed with a thin thickness, for example, 2 nm. The etch stop film can be formed of a material such as TaO, TaCO, TaON, TaCON, TaBO, TaBCO, TaBON, TaBCON, TaSbO, TaSbON, TaSbCO, TaSbCON, Si-based, or Pt-based material, and is etched by fluorine (F)-based gas. Afterward, the hardmask film 209 on the etch stop film is formed with a thickness of 4 nm. The hardmask film 209 is then coated with the resist film 210 to complete the manufacturing of the final Blankmask.

The process for manufacturing a Photomask using the Blankmask with the above configuration is as follows.

First, the pattern of the resist film 210 is formed through e-beam Writing and Develop processes, and then the hardmask film 209 is etched using the resist film pattern as an etching mask. Fluorine (F)-based etching gas is used for etching the TaBO hardmask film 209.

After removing the resist film pattern, the pattern of the hardmask film 209 is used as an etching mask to etch the absorption film 208. A chlorine (Cl₂)-based gas that does not include oxygen (O₂) is used for etching the absorption film 208.

In the present invention, the hardmask film 209 may not be removed, in which case the hardmask film 209 remains in the Photomask along with the absorption film 208 to absorb the exposure light. The hardmask film 209 can be removed by a separate etching process.

As in the other embodiment described above, when equipped with an etch stop film, the hardmask film 209 is etched by chlorine (Cl₂)-based gas that does not include oxygen (O₂), followed by the etching of the etch stop film by fluorine (F)-based gas. The hardmask film 209 is etched and removed together in the process of etching for patterning the absorption film 208. The etch stop film can be removed after patterning the absorption film 208 or remain without being removed to absorb the exposure light together with the absorption film 208.

Although details of the disclosure have been described above through a few embodiments of the disclosure with reference to the accompanying drawings, the embodiments are merely for the illustrative and descriptive purposes only but not construed as limiting the scope of the disclosure defined in the appended claims. It will be understood by a person having ordinary skill in the art that various changes and other equivalent embodiments may be made from these embodiments. Thus, the scope of the invention should be defined by the technical subject matters of the appended claims.

## Claims

1. A blankmask for extreme ultraviolet lithography, comprising:
a sub strate,
a reflective film formed on the substrate,
a capping film formed on the reflective film, and
an absorption film formed on the capping film, which includes chromium (Cr) and antimony (Sb).

2. The blankmask for extreme ultraviolet lithography according to claim 1, wherein the absorption film includes chromium (Cr) 30-60at%, antimony (Sb) 40-70at%, and nitrogen (N) 0-20(at%).

3. The blankmask for extreme ultraviolet lithography according to claim 2, wherein the nitrogen (N) content in the absorption film is at least 1at%.

4. The blankmask for extreme ultraviolet lithography according to claim 3, wherein the absorption film further includes one of oxygen (O) or carbon (C).

5. The blankmask for extreme ultraviolet lithography according to claim 4, wherein the absorption film includes oxygen (O) 0-10at%, and carbon (C) 0-10at%.

6. The blankmask for extreme ultraviolet lithography according to any one of claims 1 to 5, wherein the absorption film has an extinction coefficient (k) of 0.05-0.065 for EUV exposure light with a wavelength of 13.5nm.

7. The blankmask for extreme ultraviolet lithography according to claim 6, wherein the absorption film has a refractive index (n) of 0.930-0.945 for EUV exposure light with a wavelength of 13.5nm.

8. The blankmask for extreme ultraviolet lithography according to claim 7, wherein the absorption film has a thickness of 30-50nm.

9. The blankmask for extreme ultraviolet lithography according to claim 8, wherein the absorption film has an absolute reflectivity of 3% or less for EUV exposure light with a wavelength of 13.5nm.

10. The blankmask for extreme ultraviolet lithography according to any one of claims 1 to 9, further comprising a hardmask film formed on the absorption film, which is etched by fluorine (F)-based gas.

11. The blankmask for extreme ultraviolet lithography according to any one of claims 1 to 9, further comprising:
an etch stop film formed on the absorption film, which is etched by fluorine (F)-based gas, and
a hardmask film formed on the etch stop film, which is etched by chlorine (Cl)-based gas.

12. The blankmask for extreme ultraviolet lithography according to claim 11, wherein the etch stop film is formed of a material including one or more of tantalum (Ta), silicon (Si), platinum (Pt).

13. The blankmask for extreme ultraviolet lithography according to claim 11, wherein the etch stop film has a thickness of 2nm or less.

14. The blankmask for extreme ultraviolet lithography according to claim 12, wherein the hardmask film is formed of a material including CrNb or CrSb.

15. A photomask for extreme ultraviolet lithography manufactured using the blankmask according to any one of claims 1 to 14.
